Europäisches Patentamt

European Patent Office

Office européen des brevets

(11) Publication number: 0 652 640 A1

# EUROPEAN PATENT APPLICATION

(21) Application number: 94117610.9

(22) Date of filing: 08.11.94

(51) Int. Cl.6: H03K 17/95

(30) Priority: 08.11.93 JP 303334/93
22.07.94 JP 192072/94

(43) Date of publication of application:
10.05.95 Bulletin 95/19

(84) Designated Contracting States:
DE FR GB IT

(71) Applicant: OMRON CORPORATION
10, Tsuchido-cho
Hanazono
Ukyo-ku
Kyoto 616 (JP)

(72) Inventor: Tamino, Shinya, c/o Omron Corp.
Intellectual Property Center,
20, Igadera,
Shimokaiinji
Nagaokakyo-city
Kyoto 617 (JP)
Inventor: Sasaki, Kazuoa, c/o Omron Corp.
Intellectual Property Center,
20, Igadera,
Shimokaiinji
Nagaokakyo-city
Kyoto 617 (JP)
Inventor: Masazumi, Ueda, c/o Omron Corp.
Intellectual Property Center,
20, Igadera,
Shimokaiinji
Nagaokakyo-city
Kyoto 617 (JP)
Inventor: Takashi, Otsuka, c/o Omron Corp.
Intellectual Property Center,
20, Igadera,
Shimokaiinji
Nagaokakyo-city
Kyoto 617 (JP)

(74) Representative: Wilhelms, Rolf E., Dr. et al
WILHELMS, KILIAN & PARTNER
Patentanwälte
Eduard-Schmid-Strasse 2
D-81541 München (DE)

(54) Proximity switch.

(57) Objective: To make it significantly easier to program the sensitivity of a proximity switch with a comparatively simpler configuration.

Configuration: Circuit 21 to adjust the sensitivity is connected to oscillator circuit 2. Without using an object, the resistance value of circuit 21 is successively increased during oscillation, and the resistance value for the position in which oscillation ceases is detected. The sensitivity is set based on this resistance value. In this way the sensitivity can be set for the optimal position without the use of an object.

EP 0 652 640 A1

## Field of The Invention

This invention concerns a proximity switch. More specifically, it concerns a proximity switch with the feature that its sensitivity can be adjusted and set.

## Background Of The Invention

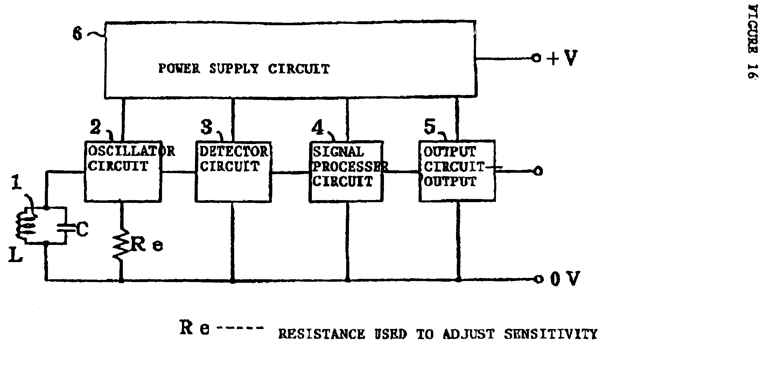

There are two types of proximity switches which use high frequency oscillation One detects a drop in amplitude of oscillation which occurs when an object is proximate. The other detects the proximity of an object based on a variation of frequency. Proximity switches which detect amplitude are widely used to detect objects containing magnetic metals. Figure 16 is a block diagram of an existing proximity switch of the type which detects amplitude. In this diagram we see parallel resonant circuit 1, consisting of oscillator coil L and capacitor C, and oscillator circuit 2. The output of oscillator circuit 2 is detected by detector circuit 3, and the drop in oscillation amplitude is detected by signal processor circuit 4. When a drop in oscillation amplitude is detected, a signal representing the detection of an object is output via output circuit 5. Power supply circuit 6 supplies power to each of the other blocks. Resistor $R_e$, which is used to adjust the sensitivity, is a component of oscillator circuit 2.

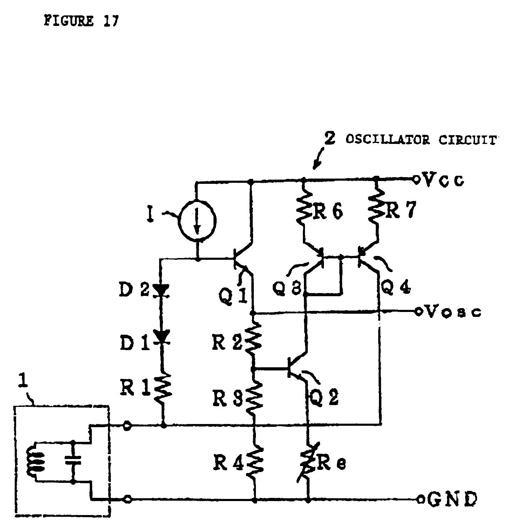

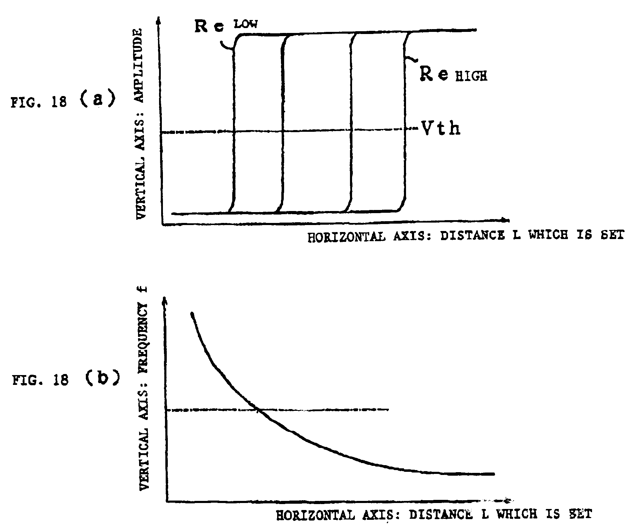

Figure 17 shows an example of a circuit which might be used for parallel resonant circuit 1 and oscillator circuit 2. In this circuit, the base of transistor $Q_1$ is connected to parallel resonant circuit 1 through resistor $R_1$ and diodes $D_1$ and $D_2$. A constant current is supplied to the base of transistor $Q_1$ by the power supply. Resistors $R_2$, $R_3$ and $R_4$ are connected in series to the emitter side of transistor $Q_1$ between the transistor and the ground terminal. The midpoint between resistors $R_2$ and $R_3$ is connected to the base of transistor $Q_2$. The aforementioned resistor $R_e$, which adjusts the sensitivity, is connected to the emitter aide of transistor $Q_2$. A current mirror circuit consisting of transistors $Q_3$ and $Q_4$ is connected to the collector side of transistor $Q_2$. A current with a value equal to that flowing from the power supply into transistor $Q_2$ is fed back to parallel resonant circuit 1 by way of transistor $Q_4$. This creates a positive feedback loop resulting in oscillation. The graph in Figure 18 (a) shows the relationship between the amplitude of oscillation and the distance of the object to be detected for various values, from low to high, of the resistance of resistor $R_e$. As can be seen from the graph, oscillation begins and ends abruptly when an object is positioned at a fixed distance.

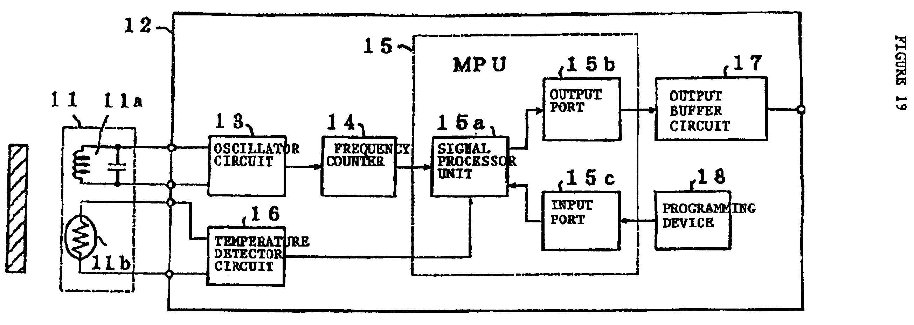

Figure 19 is a block diagram of a proximity switch which detects frequency. The type of switch shown here has a separate sensor head 11 and signal processor unit 12. Sensor head 11 contains parallel resonant circuit 11a, which consists of a coil and a capacitor, and temperature detector element 11b. Signal processor unit 12 has an oscillator circuit 13 which is connected to parallel resonant circuit 11a. Its output terminal is connected to frequency counter 14. Counter 14 detects the oscillating frequency of the oscillator circuit. Its output is connected to signal processor unit 15a, which is a microcomputer. The signal from thermostatic element 11b in sensor head 11 is input into temperature detector circuit 16 in signal processor unit 12. Circuit 16 outputs the temperature data into microcomputer 15. The microcomputer discriminates the presence or absence of an object using a specified frequency as a threshold value. Its data are output by output buffer circuit 17 by way of output port 15b. when the sensitivity is set, the setting is input to signal processor unit 15a by programming device 18 through input port 15c.

With this type of proximity switch, the frequency f varies with the distance L to the object as shown in Figure 18 (b). By teaching the switch a threshold level, then, we can adjust the operating distance.

## Problems Which This Invention Attempts to Solve

Proximity switches which operated by detecting amplitude had the following shortcomings.

Sensitivity was adjusted by the manual process of varying the resistance of resistor $R_e$, which required a certain degree of skill. The position of an adjustment was likely to vary when set by different technicians.

The fact that the angle of rotation of the variable resistor in resistor $R_e$ was not directly proportional to the detection distance made it difficult to make an optimal adjustment. The technician had no alternative but to repeatedly adjust the resistance by guessing and test the operation of the switch.

When the point of actuation was set at a long distance, the change in the conductance (sic; admittance?) of the oscillator coil which occurred due to the presence of an object would become quite small. This made it difficult to adjust the switch to its optimal point. If any spurious movement caused the variable resistor to shift position even slightly, the point of actuation would be radically changed.

The most frequent use of this proximity switch is to sense an object which is passing by; however, in this case, too, it is necessary to adjust the variable resistor and check the operation of the switch with the object in a specified position. In the case of an object which was difficult to move, adjusting the resistor was a laborious process.

Proximity switches which operated by detecting frequency had the following shortcomings.

The change in oscillating frequency due to the proximity of an object was proportionally even smaller than the change in conductance (sic) in a switch using amplitude detection. Even a small variation in frequency caused by variations of operating temperature could have a profound effect on the actuation point. For this reason the switch required a temperature detector circuit, and the microcomputer had to perform temperature compensation. During production, each component had to be screened and temperature compensated separately, resulting in a time-consuming and complicated manufacturing process.

When the proximity switch had a sensor head which was discrete from the main part of the switch, the head had to be mounted against the switch, which limited the versatility of the proximity switch in situations of actual use. If either segment became damaged, the entire installation had to be replaced.

The sensor head had to contain a temperature detector element, which made it difficult to downsize. The proliferation of the cables needed to connect the sensor head to the main part of the switch meant that more connection processes were required.

When the sensitivity was set, the threshold value was determined using the presence of an actual object. Even a setting which did not require a high degree of accuracy, such as being able to detect simply that an object has gone past, required two teaching episodes, one with an object in proximity and one without. This made operating the sensor more complex.

This invention was developed in consideration of the difficulties entailed in setting the sensitivity of existing proximity switches. Its objective was to make it possible to program the sensitivity easily without increasing the complexity of the switch.

## Summary Of The Invention

The invention disclosed in claim 1 of this application is a proximity switch which has an oscillator circuit containing an oscillator coil; a circuit connected to the aforesaid oscillator circuit, which adjusts the sensitivity by switching the feedback current to various values, a device to control the switching, which adjusts the sensitivity of the aforesaid oscillator circuit by outputting a switching signal to the aforesaid circuit; a detector circuit which detects the output of the aforesaid oscillator circuit; a signal processor circuit which distinguishes the presence or absence of an object from the continuation of oscillation or its cessation, based on the output of the aforesaid detector circuit; and a device to establish a teaching mode. This proximity switch is distinguished In the following ways. The aforesaid device to control the switching has a device to set new values of the feedback current, which, when the aforesaid teaching input device has put the switch into teaching mode when no object is proximate, varies the feedback current value of the aforesaid oscillator circuit within the range of possible adjustment, and detects the current value I (N) at the time the state of oscillation changes. It also has a device to program the sensitivity, which sets the feedback current value at I (A), a value which is larger than the corresponding value I (N) detected by the aforesaid device to set new values of the feedback current.

The invention disclosed in claim 3 of this application is a proximity switch which has an oscillator circuit containing an oscillator coil; a circuit connected to the aforesaid oscillator circuit, which adjusts the sensitivity by switching the feedback current to various values; a device to control the switching, which adjusts the sensitivity of the aforesaid oscillator circuit by outputting a switching signal to the aforesaid circuit; a detector circuit which detects the output of the aforesaid oscillator circuit; a signal processor circuit which distinguishes the presence or absence of an object from the continuation of oscillation or its cessation, based on the output of the aforesaid detector circuit; and a device to establish a teaching mode. This proximity switch is distinguished in the following ways. The aforesaid device to control the switching has a device to set new values of the feedback current, which, when the aforesaid teaching input device has put the switch into teaching mode when no object is to be detected, varies the feedback current value of the aforesaid oscillator circuit within the range of possible adjustment, and detects the feedback current value I (N) at the time the state of oscillation changes. The switching controller also has a device to program the sensitivity, which sets the feedback current value at I (A), a value which is larger than the corresponding value I (N) detected by the aforesaid device to set new values of the feedback current. It has a second device to set new values of the feedback current, which, when the aforesaid teaching input device has establish a teaching mode then an object has approximated the position where it can be detected, varies the feedback current value of the aforesaid oscillator circuit within the range of possible adjustment, and detects the current value I (E) of the feedback current at the time the state of oscillation changes. It also has a second device to program the sensitivity, which sets the feedback current value at I (B), a value midway between the values I (N) and I (E) detected by the aforesaid first and second devices to set new values of the feedback current.

The invention disclosed in claim 4 of this application is a proximity switch which has an oscillator circuit containing an oscillator coil; a circuit connected to the aforesaid oscillator circuit, which adjusts the sensitivity by switching the feedback current to various values; a device to control the switching, which adjusts the sensitivity of the aforesaid oscillator circuit by outputting a switching signal to the aforesaid circuit; a detector circuit which detects the output of the aforesaid oscillator circuit; a signal processor circuit which distinguishes the presence or absence of an object from the continuation of oscillation or its cessation, based on the output of the aforesaid detector circuit; and a device to establish a teaching mode. This proximity switch is distinguished in the following ways. The aforesaid device to control the switching has a device to set new values of the feedback current, which, when the aforesaid teaching input device has put the switch into teaching mode when no object is to be detected, varies the feedback current value of the aforesaid oscillator circuit within the range of possible adjustment, and detects the feedback current value I (N) at the time the state of oscillation changes. The switching controller also has a device to program the sensitivity, which sets the feedback current value at I (A), a value which is larger than the corresponding value I (N) detected by the aforesaid device to set new values of the feedback current. It has a second device to set new values of the feedback current, which, when the aforesaid teaching input device has establish a teaching mode when an object has approximated the position which is the threshold value for detection, varies the feedback current value of the aforesaid oscillator circuit within the range of possible adjustment, and detects the current value I (E) of the feedback current at the time the state of oscillation changes. It also has a third device to program the sensitivity, which sets the value I (C) of the feedback current to coincide with the value I (E) detected by the aforesaid first and second devices to set new values of the feedback current.

In the proximity switch which has the characteristics described in claim 1 of this application, changing the state of the switching circuit in the circuit to adjust sensitivity switches the feedback current from the oscillator circuit, If the teaching input device is set to teaching mode when no object is present, the first device to set new values of the feedback current will change the feedback current. The current value I (N) at which the state of oscillation changes will be detected, This allows the operator to check the actuation distance of an oscillator coil which is connected to the circuit. Using this value as a reference, a lower value is chosen, namely, the feedback current value I (A) in the circuit to adjust sensitivity.

With the proximity switch disclosed in claim 3 of this application, an object is brought into the position which should actuate the switch after teaching is completed without an object present, and the teaching input device is again set to teaching mode. In this way the threshold value is set at the midpoint between the value when the object is not present and that when it is.

With the proximity switch disclosed in claim 4 of this application, an object is brought into the desired position and the teaching input device is set to teaching mode. The feedback current value can be detected at which the state of oscillation changes because the object is in this position. Once this threshold value for the feedback current is preset, a correct sensitivity setting will be obtained.

Brief Description Of The Drawing

Figure 1.

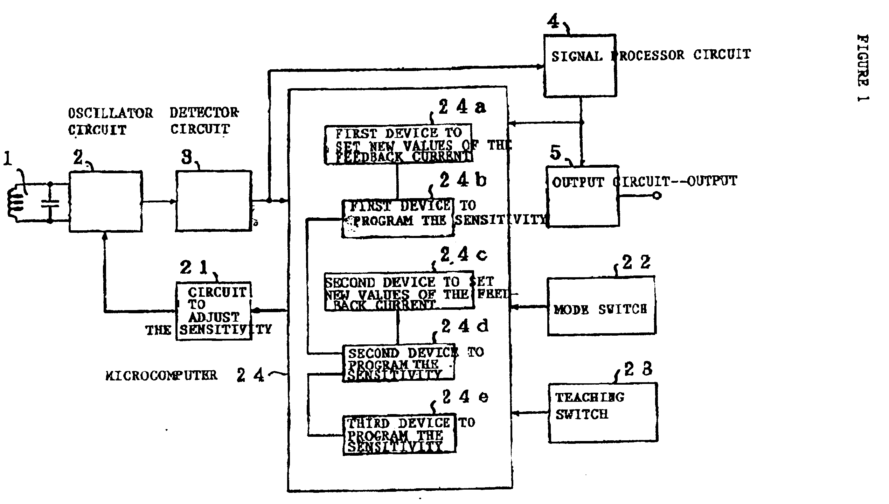

Figure 1 is a block diagram of an amplitude detection-type proximity switch which is an ideal embodiment of this invention.
Figure 2.

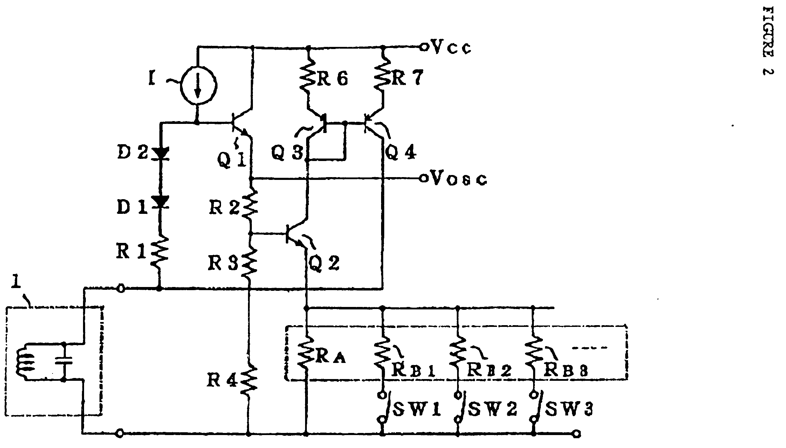

Figure 2 is a circuit diagram of the oscillator circuit and the circuit to adjust the sensitivity in an ideal embodiment of this invention.
Figure 3.

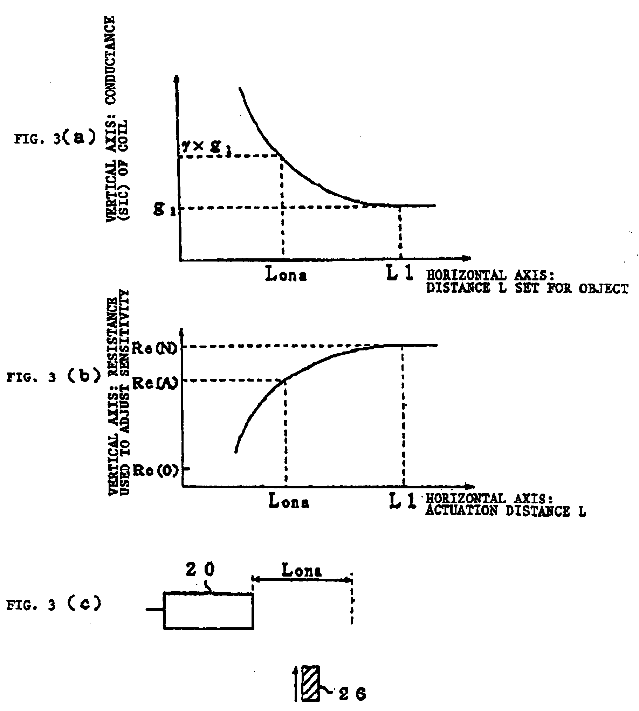

Figure 3 (a) shows the relationship between the conductance (sic) of the coil and the distance which has been set for the object. (b) is a graph showing how the value of resistance $R_e$ when oscillation begins or ends changes with actuation distance. (c) shows the relationship between the proximity switch and the object in teaching with the object to be detected not present.
Figure 4.

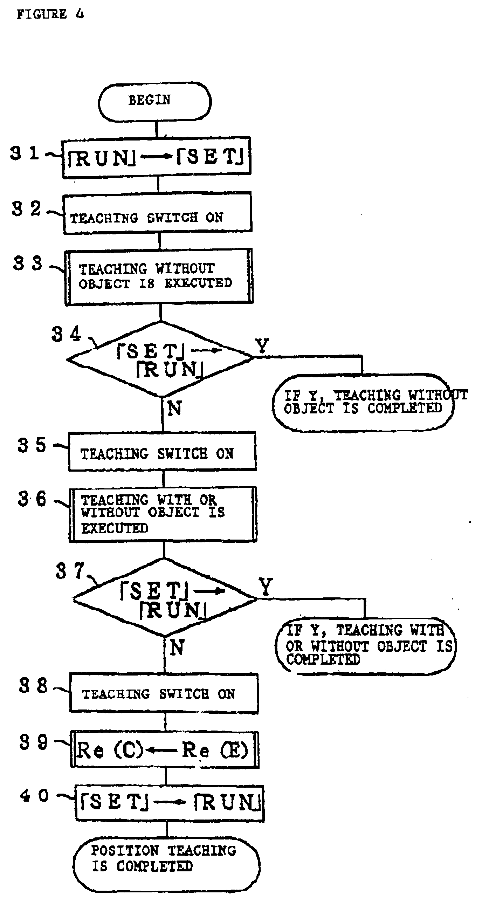

Figure 4 is a flowchart of all the teaching processing used in this embodiment.
Figure 5.

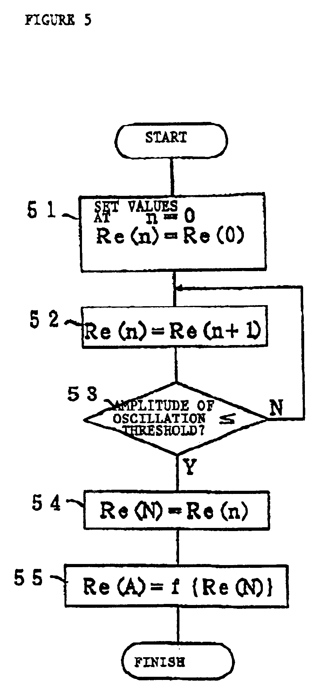

Figure 5 is a flowchart of the routine for teaching without an object.
Figure 6.

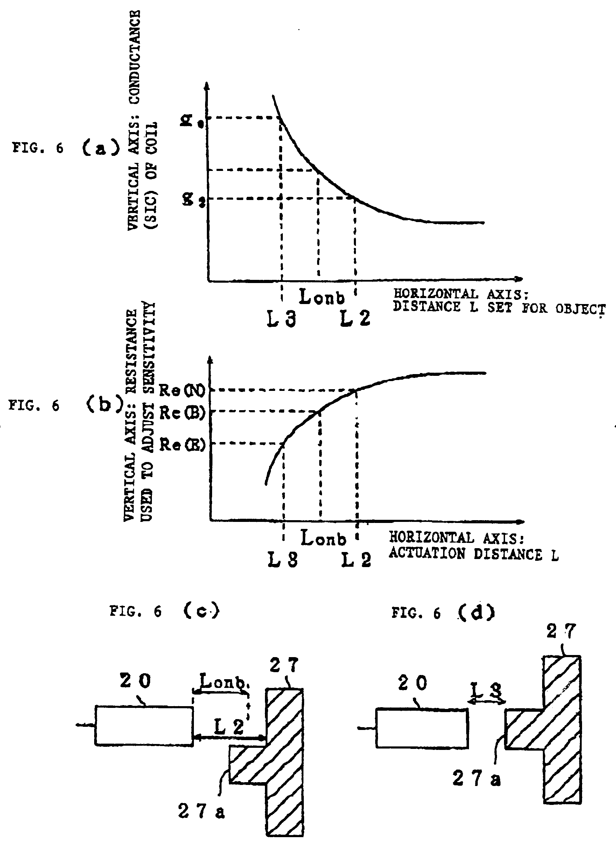

Figure 6 (a) shows the relationship between the conductance (sic) of the coil and the distance which has been set for the object. (b) is a graph showing how the value of resistance $R_e$ when oscillation begins or ends changes with actuation distance. (c) and (d) show the relationship between the proximity switch and the object in teaching with and without an object.
Figure 7.

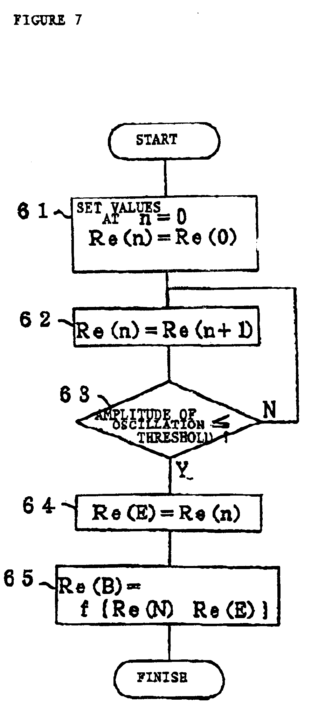

Figure 7 is a flowchart of the routine used for teaching with and without an object.
Figure 8.

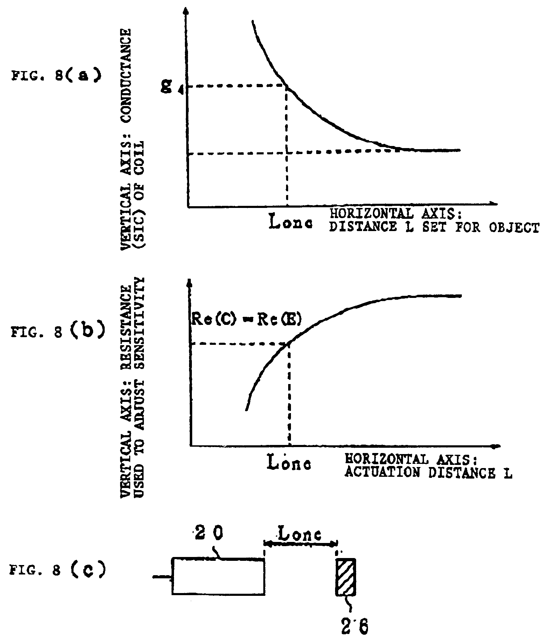

Figure 8 (a) shows the conductance (sic) of the coil with respect to the distance which has been set for the object. (b) is a graph showing how the value of resistance $R_e$ when oscillation begins or ends changes with actuation distance. (c) shows the relationship between the proximity switch and the object in position teaching.
Figure 9.

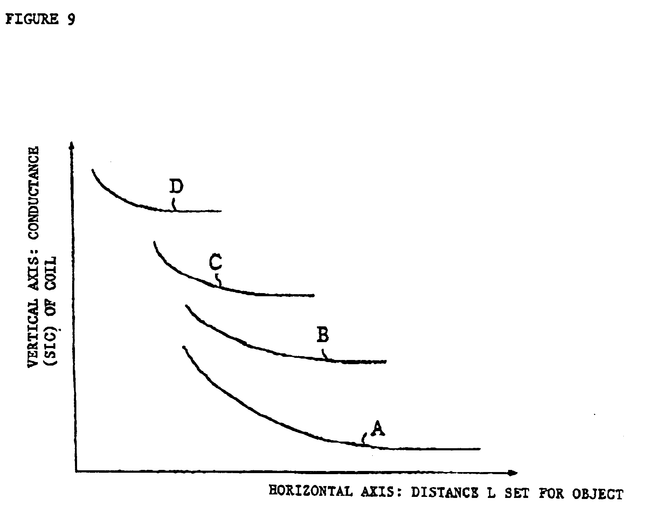

Figure 9 is a graph which shows how the conductance (sic) of the coil varies with respect to the distance which has been set for the object using sensor heads A through D.
Figure 10.

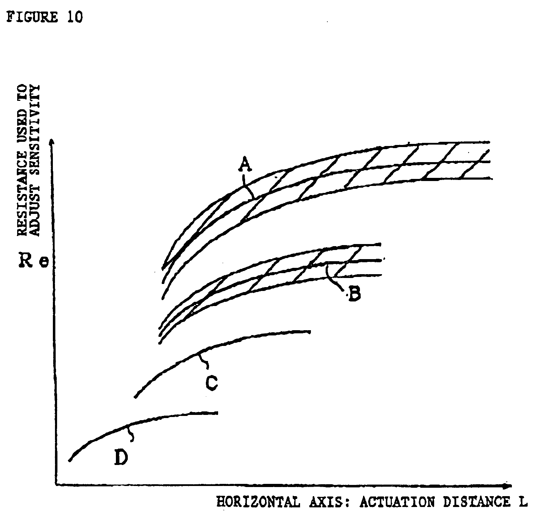

Figure 10 is a graph showing how the value of resistance $R_e$ then oscillation begins or ends changes with actuation distance for each sensor head.
Figure 11.

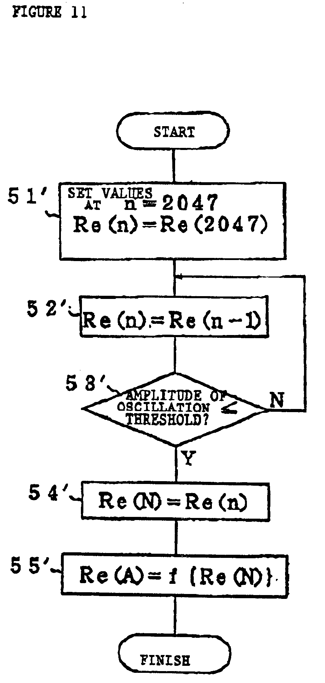

Figure 11 is a flowchart of the routine for teaching without an object used by the second ideal embodiment of this invention.
Figure 12.

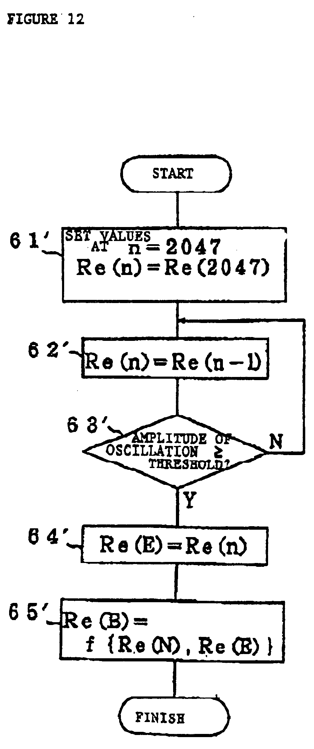

Figure 12 is a flowchart of the routine for teaching with and without an object used by the second ideal embodiment of this invention.
Figure 13.

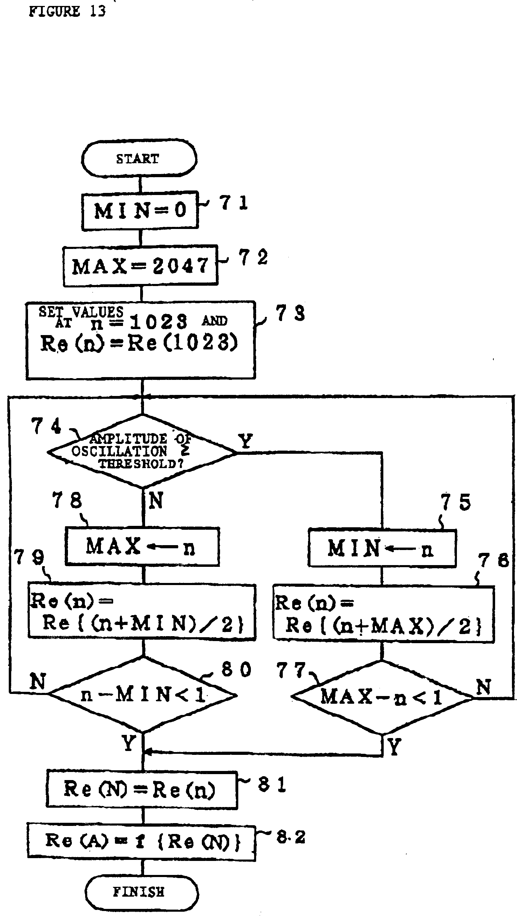

Figure 13 is a flowchart of the routine for teaching without an object used by the third ideal embodiment of this invention.
Figure 14.

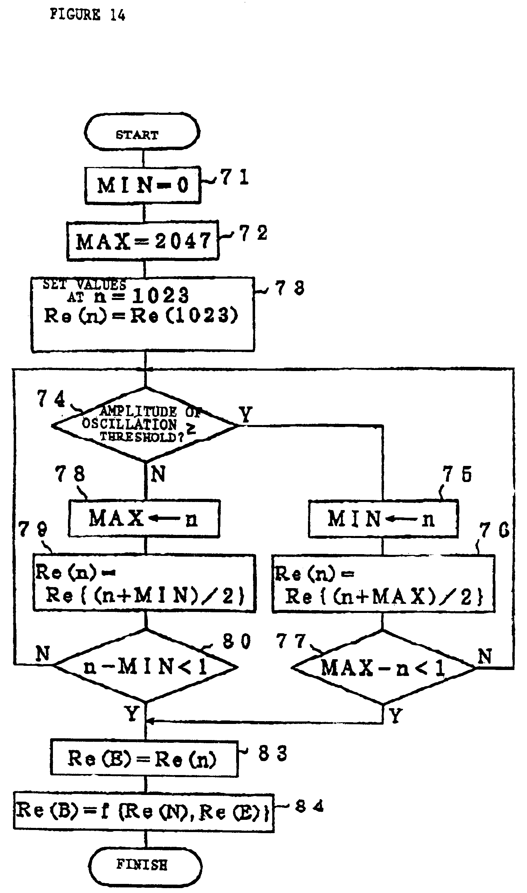

Figure 14 is a flowchart of the routine for teaching with and without an object used by the third ideal embodiment of this invention.
Figure 15.

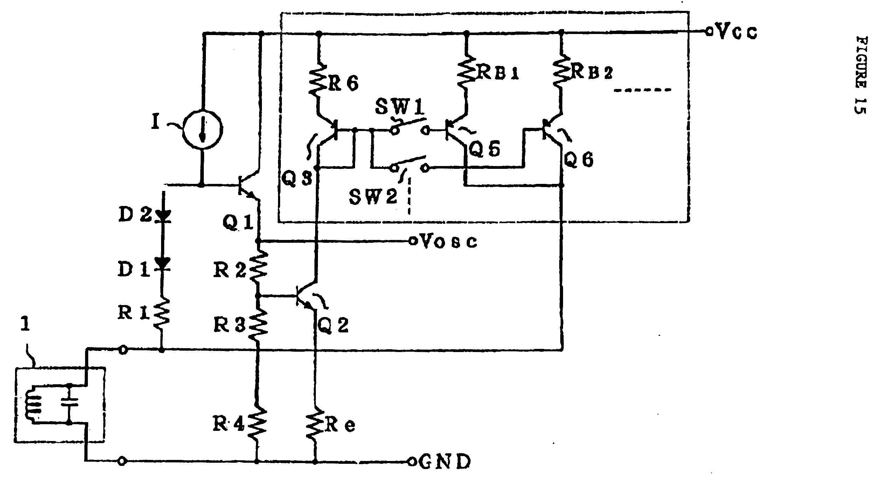

Figure 15 is a circuit diagram of the oscillator circuit and the circuit to adjust the sensitivity in another ideal embodiment of this invention.
Figure 16.

Figure 16 is a block diagram of an amplitude detection-type proximity switch belonging to the prior art.
Figure 17.

Figure 17 is a circuit diagram of the oscillator circuit in an amplitude detection-type proximity switch belonging to the prior art.
Figure 18.

Figure 18 (a) is a graph showing the amplitude of oscillation of the oscillator circuit with respect to the distance L which has been set for the object in an amplitude detection-type proximity switch. (b) is a graph showing how oscillating frequency varies with the distance set for the object.
Figure 19.

Figure 19 is a block diagram of a frequency detection-type proximity switch belonging to the prior art.

## Detailed Description Of The Invention

Figure 1 is a block diagram of proximity switch 20, a proximity switch using high-frequency oscillation which is an ideal embodiment of this invention. The parts of this switch which are identical to parts of the existing amplitude-detection type proximity switch discussed earlier have been given the same numbers, and we shall dispense with a detailed explanation of them. Like the existing switch, this embodiment has an LC parallel resonant circuit 1 and an oscillator circuit 2. On oscillator circuit 2 is adjustor circuit 21, which adjusts the sensitivity of circuit 2. In response to a switching signal from the exterior, adjustor circuit 21 changes the resistance of the adjustment resistor in the oscillator circuit and thereby adjusts the oscillator's sensitivity. The output of oscillator circuit 2 is sent to signal processor circuit 4 by way of detector circuit 3. Signal processor circuit 4 determines when the output of detector circut 3 is at a given threshold level, just as in the prior art switch. In this way it distinguishes the presence of an object. Its output is transmitted to the exterior by way of output circuit 5. In this embodiment, the proximity switch can be set in operating mode, which is called "Run", or sensitivity setting mode, which is called "Set", by mode switch 22 or, during teaching, by teaching switch 23. The signals from these switches are input into microcomputer 24. Based on the input from mode switch 22 and teaching switch 23, microcomputer 24 performs either teaching without an object present, teaching with and without an object present, or teaching of a position, as will be discussed later. The value for the sensitivity is set in adjustor circuit 21 by means of a switching signal. These components comprise the device to control the switching.

Figure 2 is a circuit diagram of parallel resonant circuit 1, oscillator circuit 2 and adjustor circuit 21 in this embodiment. The components in this diagram which are identical to components of the existing proximity switch discussed earlier have been given the same numbers, and we shall dispense with a detailed explanation of them. Like the existing switch, this proximity switch has an oscillator circuit 2, which contains diodes $D_1$ and $D_2$ and transistors $Q_1$ through $Q_4$, connected to parallel resonant circuit 1. In place of resistor $R_e$, the resistor to adjust the sensitivity of oscillator circuit 2, this switch has a group of resistors $R_A$, $R_{B1}$, $R_{B2}$, $R_{B3}$, ... connected in parallel, as shown in the diagram. Switches SW1, SW2, and so on are connected to resistors $R_{B1}$, $R_{B2}$, $R_{B3}$, and so on as switching circuits to switch among those resistors. These switches open and close in response to switching signals from microcomputer 24. The parallel resistors used in tandem replace the afore-

mentioned resistor $R_e$. This configuration allows microcomputer 24 to control the adjustment of the oscillator circuit's sensitivity. Let us assume that in this embodiment, eleven switches are used, SW1 through SW11. each connected in series to one of resistors $R_{B1}$ through $R_{B11}$. The resistance value $R_{B(1)}$ of each resistor is set at

$$R_{B1} = R_0 \times 2^i$$

(i = 1 through 11). By setting the on-off states of switches SW1 through SW11, each of which has eleven bits, we can set 2,048 steps of resistance in composite resistor $R_e$.

Figure 3 (a) is a graph showing how the conductance (sic) g of the coil in parallel resonant circuit 1 changes with respect to the set distance L of the object to be detected (the work). Figure 3 (b) shows how the actuation distance L, the distance where the oscillation ceases, varies with the value of resistor $R_e$, the (composite) resistor to adjust sensitivity. Figure 4 is a flowchart of all the operations entailed in adjusting (and teaching) the sensitivity. Teaching begins with step 31, where mode switch 22 is changed from "Run" to "Set". At this point, there is no object in front of switch 20, as shown in Figure 3 (c). When teaching switch 23 is depressed, we proceed to routine 33, and processing is executed for teaching without an object.

Figure 5 is a flowchart of the operations which constitute teaching without an object. Adjustor circuit 21 takes the resistance value which will be used to adjust the sensitivity, and which corresponds to pointer n. Pointer n will have a certain number of bits, which in this case will be eleven, allowing it to have a value between 0 and 2,047. At $R_e(0)$, all of switches SW1 through SW11 will be on, and $R_e$ will assume its minimum value. At $R_e$-(2,047), all of switches SW1 through SW11 will be off, and $R_e$ will assume its maximum value. Between these values, the resistance will vary according to n. In Step 51, pointer n will be set at zero, and resistor $R_e$ will be set at $R_e(0)$, i.e., at its minimum value. This being the case, in the absence of an object the oscillator circuit will oscillate with a steady-state amplitude, as shown in Figure 18 (a). The amplitude level will be considerably higher than the threshold level $V_{th}$ of signal processor circuit 4. We proceed to Step 52, where pointer n is incremented, and $R_e(n)$ is set in adjustor circuit 21 via the output port. We proceed to Step 53, where the amplitude of oscillation is reduced and a check is made to determine whether it is now below threshold value. If it is not, we return to Step 52 and again increment pointer n, repeating the same processing. As the value of pointer n successively increases, the value of resistor $R_e(n)$ in-

creases with it.

At some specific resistance value, the amplitude will abruptly decrease and oscillation will cease. When this happens, we proceed from Step 53 to Step 54, and resistance value $R_e(n)$ is considered to be $R_e(N)$. The oscillation of oscillator circuit 2 ceases abruptly at a fixed value of $R_e$. In Figure 3 (b), this cessation of oscillation occurs at the point where the curved line becomes flat. The distance L1 at this point is the maximum detection distance of the sensor head in parallel resonant circuit 1. It follows, then, that to insure reliable detection of an object, the detection distance which is set must be shorter than this distance. In Figure 3 (a), the conductance (sic) of the coil which corresponds to distance L1 is called $g_1$. We proceed to Step 55, where the resistance $R_e(A)$ is determined in the absence of an object by its relationship with $R_e(N)$-.$R_e(A)$ may be obtained by multiplying the resistance value of $R_e(N)$ by a specified coefficient =, say, 0.7 to 0.8 (where 0 < = < 1). Alternatively, $R_e$-(A) may be established by subtracting a given value $R_x$ from $R_e(N)$. In Steps 51 through 55, if teaching switch 23 has been actuated, microcomputer 24 varies the value of the feedback current from the adjustor circuit in the range of possible adjustments. The microcomputer performs the function of device 24a, the first device to set new values of the feedback current, which detects the current value I (N) at the moment the state of oscillation changes and, in this embodiment, also detects $R_e(N)$. It also performs the function of device 24b, the first device to program the sensitivity, which calculates feedback current I (A) using the feedback current I (N) at the moment the state of oscillation changes, and in this embodiment also calculates the resistance $R_e(A)$ used to adjust the sensitivity.

When routine 33 has been completed, we proceed to Step 34 in Figure 4 and check whether mode switch 22 has been set to "Run". If it has, we proceed to normal operating mode, since the sensitivity has been set through teaching without an object. The distance $L_{ona}$ which corresponds to the $R_e(A)$ which has been set is the distance set by teaching without an object. If object 26 in Figure 3 (c) passes the switch anywhere within distance $L_{ona}$, it will be detected.

We shall next explain the processing involved in teaching with and without an object. Figure 6 (a) is a graph showing how the conductance (sic) of the coil varies with the set distance L of the work when the switch is taught both with and without an object. (b) is a graph showing how the actuation distance L where oscillation ceases varies with the value of (composite) resistor $R_e$, the resistor used to adjust the sensitivity. (c) and (d) show the relationship between proximity switch 20 and object 27 at these times. Teaching with and without an object can be used, for example, in the case shown in Figure 6 (c), where the switch must detect a protuberance 27a which juts out next to the switch on an object. 27 whose surface has a number of levels. In this case, the operator selects setting mode when the portion of object 27 which does not protrude first comes in front of proximity switch 20, and he depresses teaching switch 23 for the first time. At this point the distance from proximity switch 20 to the surface of object 27 which is to be detected is L2. We proceed through the aforementioned steps 31 and 32 to routine 33, where the same processing is performed as in teaching without an object. We use the value $R_e(N)$ obtained in this teaching to set a sensitivity value for teaching with and without an object. The conductance (sic) of the coil at distance L2 is $g_2$. In Step 35, without setting mode switch 22 to "Run", the operator allows protrusion 27a on object 27 to come in line with switch 20, as shown in Figure 6 (d), and he depresses teaching switch 23. The distance between proximity switch 20 and object 27 at this point is L3. When switch 23 is depressed, we proceed from step 35 to routine 36, where teaching with and without an object is executed.

Routine 30 is pictured in Figure 7. First, in step 61, the adjustment resistance is set at $R_e$ (0), its minimum value, just as in routine 33. We proceed to step 62 and increment pointer n, thus causing the resistance to be set at $R_e$ (n). We proceed to step 63, where we chock whether the amplitude has fallen below the threshold value. If it has not, we return to step 62 and repeat the processing one more time. When the amplitude is below the threshold, we go to step 64, and the resistance $R_e$ - (n) at that time is considered to be $R_e$ (E). The conductance (sic) of the coil at distance L3 we shall call $g_3$. We then go to step 65, where the resistance value $R_e$ (B) of teaching with and without an object is set somewhere between $R_e$ (N) and $R_e$ (E). The value $R_e$ (B) may be the midpoint value, or it may be a value closer to $R_e$ (N) or $R_e$ (E).

In Steps 61 through 64, if the teaching switch has been actuated a second time, microcomputer 24 varies the value of the feedback current from the oscillator circuit within the range of possible adjustments. The microcomputer performs the function of device 24c, the second device to set new values of the feedback current, which detects the feedback current value I (E) at the moment the state of oscillation changes and, in this case, also detects $R_e(E)$. It also performs the function of device 24d, the second device to program the sensitivity. When the change in the state of oscillation is detected by the second device to set new values of the feedback current in step 65, the microcomputer sets the feedback current value I (B) halfway between the values I (N) and I (E) which were detected by the first and second updating devices; and in this case, it also sets $R_e$ (B).

Once routine 36 has been completed, we go to step 37 and check whether mode switch 22 has been set to "Run": If it has, the presence of an object will be detected based on the resistance value $R_e$ (B) which was set by teaching with and without an object. In this case, the distance $L_{onb}$ shown in Figure 6 (c) will be used as the threshold distance, and the switch has been adjusted so that it will only detect protrusion 27a on object 27, which has a number of different levels.

We shall next explain the processing involved in the teaching of a position. Figure 8 (a) is a graph showing how the conductance (sic) of the coil varies with the distance L of an object when the detection distance has been set by position teaching. (b) is a graph showing how the actuation distance L where oscillation ceases varies with the value of (composite) resistor $R_e$, the resistor used to adjust the sensitivity. (c) shows the relationship between proximity switch 20 and object 26 at this time. In position teaching, teaching switch 23 is depressed when there is no object in front of proximity switch 20. We proceed through steps 31 and 32 to step 33, where adjustment resistance $R_e$ is gradually increased from its minimum value, as discussed earlier, and resistance $R_e$ (N) is set. At this point, teaching without an object is executed. Then an object is placed in position $L_{onc}$, the spot where proximity switch 20 is to position it, as shown in Figure 8 (c). Teaching switch 23 is then depressed. Routine 36 is executed, as shown in Figure 7, and the adjustment resistance $R_e$ is once again gradually increased from its minimum value, and the resistance value at the moment the oscillation ceases is taken to be $R_e$ (E). In teaching with and without an object, the sensitivity value $R_e$ (B) is established. In step 38, teaching switch 23 is again turned on. We proceed to step 39, where position teaching is executed. The value $R_e$ (E), which was set in step 64 of routine 36, is used as the adjustment value $R_e$ (C) for position teaching. The conductance (sic) of the coil at this time we shall call $g_4$. When the sensitivity adjustment in position teaching has been completed, we go to step 40, where we set mode switch 22 to "Run", and the processing is finished. The distance $L_{onc}$ from proximity switch 20 to object 26 in Figure 8 (c) will be used as the threshold value. When an object approaches proximity switch 20 from a distance, it will be detected in the position which has been set. In steps 38 and 39, microcomputer 24 performs the function of device 24e, the third device to program the sensitivity, which sets the current value I (E) of the feedback current at the moment the second updating device detects a change in state of oscillation, and in this case sets the resistance value $R_e$ (E), so as to coincide with feedback current value I (C) and resistance value $R_e$ (C).

This embodiment of a proximity switch is the type of switch with a discrete head, in which parallel resonant circuit 1 is separate from the main body of the switch. This switch could be used in a situation in which various parallel resonant circuits were used as sensor heads. Curves A to D in Figure 9 show how the conductance (sic) of the various oscillator coils changes with the set distance L to the object in different sensor heads. Figure 10 is a graph of the corresponding relationship between the adjustment resistance $R_e$ which is set and the actuation distance L. When various sensor heads are used, as in this case, resistance $R_e$ is set at its minimum value for teaching without an object, as discussed earlier, and then successively increased. In this way the resistance value at the moment the oscillation ceases can easily be detected. The rightmost point on each of the curves shown in Figure 10 is the point where oscillation ceases. It represents the resistance $R_e$-(N) in step 54 of Figure 5.

When a variety of different sensor heads are used, the relative variation due to the characteristics of each sensor head, for example, the width indicated by hatching on curve A, is smaller than the relative variation due to the type of sensor head. It is thus possible to specify each of the heads. A different formula should be used for each sensor head to relate the two resistance values in the aforesaid step 55. In other words, if $R_e$ (N) is multiplied by a specified coefficient = to yield $R_e$-(A), this coefficient = should be varied for each type of sensor head. If $R_e$ (A) is to be set at a value lower than $R_e$ (N) by a specified amount $R_x$, the value $R_x$ which is to be subtracted can be varied for each type of sensor head. $R_x$ (A), for example, would be selected as the value to be subtracted from curve A in Figure 10, regardless of the variance. $R_x$ (B) would be selected for curve B, and $R_x$ (C) and $R_x$ (D) would be selected for curves C and D, respectively. These values would fulfill the condition that $R_x$ (A) > $R_x$ (B) > $R_x$ (C) > $R_x$ (D). In this way the threshold can be set at an optimal value regardless of the type of sensor head used or the variance of the head itself.

In the embodiment which we have been discussing, when the switch is taught without using an object in routine 33, resistance value $R_e$ (n) is set at its minimum value and successively increased, as shown in Figure 5. However, it would be equally acceptable to set $R_e$ at its maximum value and successively decrement it. Figure 11 is a flowchart of the processing used in this routine for teaching without an object. In this routine, pointer n has 11 bits, i.e., it can take a value between 0 and 2.047.

In step 51', pointer n is set at its maximum value, 2,047. Adjustment resistance $R_e$ (n) is also set at $R_e$ (2,047), and all of switches SW1 through SW14 are turned off, indicating that $R_e$ is at its maximum. This being the case, the oscillator circuit will not oscillate when there is no object in its proximity, as shown in Figure 17 (a) (sic). The amplitude will be below the threshold value. We proceed to step 52', where pointer n is decremented, and $R_e$ (n) is set in adjustor circuit 21 by way of the output port. We then go to step 53', where we check whether the increased amplitude of oscillation has now crossed the threshold value. If it has not, we go back to step 52', decrement pointer n, and repeat the same processing. As the value of pointer n successively decreases, the value of adjustment resistance $R_e$-(n) also decreases.

When the resistance reached a specific value, the amplitude will increase abruptly, and oscillation will commence. When this happens, we proceed from step 53' to step 54', and the resistance value $R_e$ (n) at this time is taken as $R_e$ (N). Oscillator circuit 2 will begin to oscillate abruptly at a certain value of $R_e$. This value is shown in Figure 3 (b) as the point which comes in contact with the curve. The distance L1 at this time is the maximum detection distance of the sensor head in parallel resonant circuit 1. It follows, then, that to insure reliable detection of an object, the detection distance which is set must be shorter than this distance. In Figure 3 (a), the conductance (sic) of the coil which corresponds to distance L1 is called $g_1$. We proceed to Step 55', where the resistance $R_e$(A) is determined in the absence of an object by its relationship with $R_e$(N). Here, just as in Step 55, $R_e$(A) may be obtained by multiplying the resistance value of $R_e$(N) by a specified coefficient or by subtracting a fixed value from it.

Figure 12 is a flowchart of another routine for teaching with and without an object. In this routine, just as in Figure 11, the adjustment resistance is set at $R_e$ (2,047), i.e., its maximum value, in Step 61'. We go to step 62', decrement pointer n, and set the new resistance value at $R_e$ (n). In step 63', we check whether the current amplitude exceeds the threshold value. If it does not, we return to step 62' and repeat the same processing. When the amplitude exceeds the threshold value, we go to step 64', where we take the current resistance value $R_e$ (n) as $R_e$ (E). The conductance (sic) of the coil at distance L3 we shall call $g_3$. we move to step 65', where we set resistance value $R_e$ (B), the value obtained by teaching with and without an object, somewhere between values $R_e$ (N) and $R_e$-(E). The value $R_e$ (B) may be the midpoint value, or it may he a value closer to $R_e$ (N) or $R_e$ (E).

Figure 13 is a flowchart of another routine for teaching without an object. In the aforementioned flowcharts for teaching without an object which were shown in Figures 5 and 11, the resistance value $R_e$ was successively changed, beginning with either a minimum or a maximum value. This requires a large number of switching circuits for the resistor. The routine shown in the flowchart in Figure 13 was designed to reduce the number of circuits. When the operation begins, the variable MIN is set at 0 and the variable MAX at 2,047 in steps 71 and 72. We go to step 73, where pointer n is set at its midpoint value, i.e., 1,023, and resistance value $R_e$ (n) is set at $R_e$ (1,023). In step 74, we check whether the amplitude exceeds the threshold value. If it does, we go to step 75 and enter the value n as the minimum value MIN. If, for example, the threshold value $V_{th}$ is crossed when n is 1,400, the amplitude of oscillation will be greater than $V_{th}$ when pointer n is 1,023. In step 75, we substitute pointer n (in this case, 1,023) for the variable MIN. We go to step 76, where we set the resistance at a value midway between pointer n and MAX. This will be the value midway between 2,047 and 1,023, or 1,535. Since in this case the value of MAX - n will not be less than 1, we go from step 77 back to step 74 and repeat the same processing. The resistance value $R_e$ (n) is set at $R_e$ (1,535), so the amplitude of oscillation will be below the threshold value, and we move to step 78. At this time we substitute the maximum value MAX for pointer n, and in step 79 we set the resistance value $R_e$ (n) at a point midway between the pointer and the minimum value MIN. Thus resistance $R_e$ becomes $R_e$ (1,279). Pointer n - MIN is not less than 1, so we return to step 74 and repeat the same processing. If we successively repeat the processing in steps 74 through 80, it will not take long to set the pointer at a value equal to the threshold value. The value of pointer n at this time is taken as resistance value $R_e$ (N) (Step 81). $R_e$ (A) is set with reference to $R_e$ (N) just as in the first and second embodiments discussed earlier. This routine allows us to teach the switch without using an object in an extremely short time.

Figure 14 is a flowchart of the processing involved in teaching with and without an object. Since steps 71 through 80 are identical to those in Figure 13, we shall omit their explanation. In step 83, the value $R_e$ (n) which we have obtained is taken as $R_e$ (E). In step 84, the resistance value $R_e$ (B), the result of teaching with and without an object, is set just as in the previous embodiments, based on the values $R_e$ (N) and $R_e$ (E) which have been obtained. With this routine, too, the number of switching circuits required for the resistance is far lower than in the embodiments pictured in Figures 7 and 12. This routine also requires less teaching time.

Each of the embodiments discussed above is a high-frequency oscillation-type proximity switch. However, the teaching of this invention can also be applied to a hard oscillation-type switch in which oscillation begins quickly at a fixed distance. In other words, the teaching stipulated in this invention can be applied in a capacitance-type proximity switch if the actuation distance can be continuously varied from the exterior.

In the embodiments discussed here, the circuit to adjust the sensitivity has a parallel group of resistors and a switching circuit for adjustment resistor $R_e$, which is connected to the emitter of transistor $Q_2$ in the oscillator circuit. This arrangement allows the resistance value to be varied. However, it would be equally acceptable to connect the resistors in series and use a switching circuit to short them. Resistors $R_6$ and $R_7$ in Figure 2, which determine the feedback current to the current mirror circuit consisting of transistors $Q_3$ and $Q_4$, could also be varied by a switching signal. The feedback current to the oscillator circuit need not be adjusted only by varying the value of the emitter resistance. We could, for example, use a current mirror circuit to switch the feedback current, as pictured in Figure 15. When the current mirror circuit was switched, the feedback current value would be varied. In Figure 15, transistors $Q_5$, $Q_6$, and so on take the place of transistor $Q_4$ in Figure 2. The resistances of their collectors are preset in the same way as $R_{B1}$ and $R_{B2}$ in Figure 2. Their base connections are switched by switches SW1, SW2, and so on to vary the feedback current. The constant current value can be varied using a FET, and various other schemes are also possible.

Effects of the Invention

As has been explained above in detail, with the invention disclosed in claim 1 of this application, the state of oscillation as dependent on the feedback current in the oscillator circuit is detected. The distance to the object and the amplitude of oscillation do not vary continuously. In an oscillator circuit such that oscillation ceases abruptly when an object approaching the switch reaches a certain position, the distance can be adjusted easily by changing the sensitivity of the oscillator. When the switch is taught without using an object, the feedback current is obtained when the state of oscillation changes without the approach of an object. The optimal sensitivity can be attained based on this value. The switch can be adjusted to its maximum sensitivity for reliable detection merely by depressing the teaching switch once without requiring the use of an object. This switch can be used for most applications which do not require rigorous accuracy. Its sensitivity can easily be adjusted optimally in a simple operation which is not dependent on the operator's feel or experience. Sensitivity can be set at its optimal point in environments where there are metals or other objects present. Since the switch does not employ a variable resistor, as prior art switches did, it is more resistant to spurious movements. Because an amplitude-detection type switch uses a change in conductance (sic), which is characterized by a high sensitivity, it can detect an object in a stable fashion at a long distance. If the proximity switch has a discrete sensor head, the head will not require a temperature detector element, and it can be made smaller. If the sensor head is replaced, the optimal sensitivity can be set for the new head. A prior art sensor head can be used without modification.

The invention disclosed in claim 2 of this application is a proximity switch to which a number of sensor heads are connected. In this switch, the optimal sensitivity can be set for each sensor head by varying the transformation equation used for each head. With the invention disclosed in claim 3 of this application, the switch can easily be adjusted to discriminate one of the surfaces on an object with a number of surfaces at different levels. The sensitivity can be adjusted not only to discriminate an object with a number of levels, but also to discriminate an object from its background. This insures reliable detection. The invention disclosed in claim 4 of this application allows the operator to easily adjust the sensitivity so as to create a threshold in a given location.

## Claims

1.   A proximity switch, comprising:

an oscillator circuit having an oscillator coil;

a sensitivity circuit connects to said oscillator circuit, which adjusts a sensitivity by switching a feedback current to various values;

a switching controller to control switching, which adjusts said sensitivity of said oscillator circuit by outputting a switching signal to said oscillator circuit;

a detector circuit which detects in output of said oscillator circuit;

a signal processor circuit which distinguishes a presence or an absence of an object from a continuation of oscillation or its cessation, based on said outputting of said detector circuit; and

a teaching input device to establish a teaching mode,

wherein said switching controller, comprising;

a first now value setting device to set new values of said feedback current, which, when said teaching input device is in said teaching mode when no object is proximate, varies said feedback current value of said oscillator circuit within a range of possible adjustment, and detects a current value I (N) at the time a state of oscillation changes; and

a first sensitivity setting device to program a sensitivity, which sets said feedback current value at I (A), a value which is larger the a corresponding value I (N) detected by said new value setting device.

2.   A proximity switch claimed 1, wherein said first sensitivity setting device to program a sensitivity sets value I (A) by varying a transformation equation between I (N) and I (A) according to a current value I (N) detected by said new value setting device to set new values of said feedback current.

3.   A proximity switch, comprising:

an oscillator circuit having an oscillator coil;

a sensitivity circuit connected to said oscillator circuit, which adjusts a sensitivity by switching a feedback current to various values;

a switching controller to control switching, which adjusts said sensitivity of said oscillator circuit by outputting a switching signal to said oscillator circuit;

a detector circuit which detects an output of said oscillator circuit;

a signal processor circuit which distinguishes a presence or an absence of an object from a continuation of oscillation or its cessation, based on said outputting of said detector circuit; and

a teaching input device to establish a teaching mode,

wherein said switching controller, comprising;

a first now value setting device to set new values of said feedback current, which, when said teaching input device is in said teaching mode when no object is present to be detected, varies said feedback current value of said oscillator circuit within a range of possible adjustment, and detects a current value I (N) at the time a state of oscillation changes;

a first sensitivity setting device to program a sensitivity, which sets said feedback current value at I (A), a value which is larger than a corresponding value I (N) detected by said new value setting device;

a second new value setting device to set new values of said feedback current, which, when said teaching input device is in said teaching mode when an object has approximated the position where it can be detected, varies said feedback current value or said oscillator circuit within said range of possible adjustment, and detects a current value I (E) at the time the state of oscillation changes; and

a second sensitivity setting device to set new value of said feedback current at a value midway between said values I (N) and I (E) detected by said first and second new value setting devices.

4. A proximity switch, comprising:

an oscillator circuit having an oscillator coil;

a circuit connected to said oscillator circuit, which adjusts the sensitivity by switching a feedback current to various values;

a switching controller to control switching, which adjusts a sensitivity of said oscillator circuit by outputting a switching signal to said oscillator circuit; a detector circuit which detects an output of said oscillator circuit;

a signal processor circuit which distinguishes a presence or an absence of an object from a continuation of oscillation or its cessation, based on said outputting of said detector circuit; and

a teaching input device to establish a teaching mode,
wherein said switching controller, comprising;

a first new value setting device to set new values of said feedback current, which, when said teaching input device is in said teaching mode when no object is proximate, varies said feedback current value of said oscillator circuit within a range of possible adjustment, and detects a current value I (N) at the time a state of oscillation changes; and

a second new value setting device to set new values of said feedback current, which, when said teaching input device is in said teaching mode when an object has approximated the position where it can be detected, varies said feedback current value of said oscillator circuit within said range of possible adjustment, and detects a current value I (E) at the time the state of oscillation changes; and

a third sensitivity setting device to set new value of said feedback current at a value to coincide with said current I (E) detected by said first and second devices to set new values of said feedback current.

FIGURE 1

FIGURE 2

FIG. 3(a)

**VERTICAL AXIS: CONDUCTANCE (SIC) OF COIL**

$\gamma \times g_1$

$g_1$

Lona    L1    **HORIZONTAL AXIS: DISTANCE L SET FOR OBJECT**

FIG. 3 (b)

**VERTICAL AXIS: RESISTANCE USED TO ADJUST SENSITIVITY**

Re(N)

Re(A)

Re(0)

Lona    L1    **HORIZONTAL AXIS: ACTUATION DISTANCE L**

FIG. 3 (c)

20    Lona

26

14

FIGURE 4

```
                    ┌─────────────┐
                    │    BEGIN    │
                    └──────┬──────┘
                           │
   31 ─┐    ┌──────────────────────────┐
        └── │  「RUN」 ──→ 「SET」       │
            └──────────────┬───────────┘
                           │
   32 ─┐    ┌──────────────────────────┐
        └── │  TEACHING SWITCH ON       │
            └──────────────┬───────────┘
                           │
   33 ─┐    ┌──────────────────────────┐
        └── │  TEACHING WITHOUT         │
            │  OBJECT IS EXECUTED       │
            └──────────────┬───────────┘
                           │
   34 ─┐         ◇─────────────◇
        └──     ╱  「SET」 ──→   ╲ ──→ Y ──┐
               ╲   「RUN」       ╱         │
                ◇─────────────◇           │
                       │ N       ┌────────────────────────┐
                       │         │ IF Y, TEACHING WITHOUT  │
                       │         │ OBJECT IS COMPLETED      │
                       │         └────────────────────────┘
   35 ─┐    ┌──────────────────────────┐
        └── │  TEACHING SWITCH ON       │
            └──────────────┬───────────┘
                           │
   36 ─┐    ┌──────────────────────────┐
        └── │  TEACHING WITH OR         │
            │  WITHOUT OBJECT IS        │
            │  EXECUTED                 │
            └──────────────┬───────────┘
                           │
   37 ─┐         ◇─────────────◇
        └──     ╱  「SET」 ──→   ╲ ──→ Y ──┐
               ╲   「RUN」       ╱         │
                ◇─────────────◇           │
                       │ N       ┌────────────────────────┐
                       │         │ IF Y, TEACHING WITH     │
                       │         │ OR WITHOUT OBJECT IS     │
                       │         │ COMPLETED                │
                       │         └────────────────────────┘
   38 ─┐    ┌──────────────────────────┐
        └── │  TEACHING SWITCH ON       │
            └──────────────┬───────────┘
                           │
   39 ─┐    ┌──────────────────────────┐
        └── │  Re (C) ←── Re (E)        │
            └──────────────┬───────────┘
                           │
   40 ─┐    ┌──────────────────────────┐
        └── │  「SET」 ──→ 「RUN」       │
            └──────────────┬───────────┘
                           │
            ┌──────────────────────────┐
            │  POSITION TEACHING        │
            │  IS COMPLETED             │
            └──────────────────────────┘
```

FIGURE 5

START

5 1 — SET VALUES AT $n = 0$
$Re(n) = Re(0)$

5 2 — $Re(n) = Re(n+1)$

5 3 — AMPLITUDE OF OSCILLATION $\leq$ THRESHOLD?   N

Y

5 4 — $Re(N) = Re(n)$

5 5 — $Re(A) = f\{Re(N)\}$

FINISH

FIG. 6 (a)

VERTICAL AXIS: CONDUCTANCE (SIG) OF COIL

$g_1$

$g_2$

Lonb

L3   L2

HORIZONTAL AXIS: DISTANCE L SET FOR OBJECT

FIG. 6 (b)

VERTICAL AXIS: RESISTANCE USED TO ADJUST SENSITIVITY

Re(N)

Re(B)

Re(R)

Lonb

L3   L2

HORIZONTAL AXIS: ACTUATION DISTANCE L

FIG. 6 (c)

20

Lonb

27

L2

27a

FIG. 6 (d)

20

L3

27

27a

FIGURE 7

```
                    ┌──────────────┐
                    │    START     │
                    └──────┬───────┘
                           │
          ┌────────────────────────────────┐
    6 1 ──│ SET VALUES                      │
          │   AT   n = 0                    │
          │  Re (n) = Re (0)                │
          └────────────────┬───────────────┘
                           │
          ┌────────────────────────────────┐
    6 2 ──│  Re (n) = Re (n + 1)            │
          └────────────────┬───────────────┘
                           │
                       ╱───────╲
    6 3 ─────        ╱           ╲
               ╱  AMPLITUDE OF     ╲    N
              ╱   OSCILLATION  ≦     ╲──────┐
               ╲    THRESHOLD ?     ╱       │
                ╲                  ╱        │
                 ╲────────────────╱         │
                         │ Y                │
          ┌────────────────────────────────┐
    6 4 ──│   Re (E) = Re (n)              │
          └────────────────┬───────────────┘
                           │
          ┌────────────────────────────────┐
    6 5 ──│ Re (B) =                        │
          │    f [Re (N)   Re (E)]          │
          └────────────────┬───────────────┘
                           │
                    ┌──────────────┐
                    │    FINISH     │
                    └──────────────┘
```

FIG. 8(a)

VERTICAL AXIS: CONDUCTANCE (SIC) OF COIL

g

Lonc

HORIZONTAL AXIS: DISTANCE L SET FOR OBJECT

FIG. 8 (b)

VERTICAL AXIS: RESISTANCE USED TO ADJUST SENSITIVITY

$Re(C) = Re(E)$

Lonc

HORIZONTAL AXIS: ACTUATION DISTANCE L

FIG. 8 (c)

2 0

Lonc

2 6

FIGURE 9

VERTICAL AXIS: CONDUCTANCE (SLC) OF COIL

D

C

B

A

HORIZONTAL AXIS: DISTANCE L SET FOR OBJECT

FIGURE 10

HORIZONTAL AXIS: ACTUATION DISTANCE L

FIGURE 11

```
              ┌─────────┐
              │  START  │
              └────┬────┘
                   │
   5 1' ┌──────────┴──────────────┐
        │ SET VALUES              │
        │   AT   n = 2047         │
        │  Re (n) = Re (2047)     │
        └──────────┬──────────────┘
                   │        ┌──────────┐
   5 2' ┌──────────┴────────┴───┐     │
        │  Re (n) = Re (n - 1)  │     │
        └──────────┬────────────┘     │
                   │                  │
   5 8'         ╱──┴──╲               │
           ╱ AMPLITUDE OF ╲    N      │
          ⟨  OSCILLATION    ⟩─────────┘
           ╲ THRESHOLD? ╱
              ╲──┬──╱
                 │ Y
   5 4' ┌────────┴────────┐
        │  Re (N) = Re (n) │
        └────────┬────────┘
                 │
   5 5' ┌────────┴──────────────┐
        │  Re (A) = f {Re (N)}  │
        └────────┬──────────────┘
                 │
           ┌─────┴─────┐
           │  FINISH   │
           └───────────┘
```

FIGURE 12

```
                    ( START )
                        │
   6 1'   ┌─────────────────────────────┐
          │ SET VALUES                   │
          │     AT   n = 2047            │
          │   Re(n)=Re(2047)            │
          └─────────────────────────────┘
                        │
                        │◄──────────────┐
   6 2'   ┌──────────────────────┐      │
          │ Re(n)=Re(n−1)        │      │
          └──────────────────────┘      │
                        │               │
   6 3'           ╱─────────────╲       │
                 ╱  AMPLITUDE OF  ╲  N   │
                ╱  OSCILLATION ≧   ╲─────┘
                ╲    THRESHOLD?    ╱
                 ╲───────────────╱
                        │ Y
   6 4'   ┌──────────────────────┐
          │   Re(E)=Re(n)        │
          └──────────────────────┘
                        │
   6 5'   ┌──────────────────────┐
          │ Re(B)=               │
          │   f {Re(N), Re(E)}  │
          └──────────────────────┘
                        │
                   ( FINISH )
```

FIGURE 13

```
                    ┌──────────┐
                    │  START   │
                    └────┬─────┘
                    ┌────┴─────┐
                    │ MIN=0    │ ～ 71
                    └────┬─────┘
                ┌────────┴────────┐
                │  MAX=2047       │ ～ 72
                └────────┬────────┘
         ┌───────────────┴───────────────┐
         │ SET VALUES AT n=1023 AND       │ ～ 73
         │  Re(n)=Re(1023)               │
         └───────────────┬───────────────┘
```

74   AMPLITUDE OF OSCILLATION ≧ THRESHOLD?   → Y

N

78   MAX ← n                    75   MIN ← n

79   Re(n) = Re{(n+MIN)/2}      76   Re(n) = Re{(n+MAX)/2}

N    80  n−MIN<1                 77  MAX−n<1    N

Y                                Y

Re(N) = Re(n)   ～ 81

Re(A) = f {Re(N)}   ～ 8·2

```
                    ┌──────────┐
                    │ FINISH   │
                    └──────────┘
```

EP 0 652 640 A1

FIGURE 14

FIGURE 14 flowchart:

- START
- MIN = 0 — 71
- MAX = 2047 — 72
- SET VALUES AT n = 1023, Re(n) = Re(1023) — 73
- AMPLITUDE OF OSCILLATION ≧ THRESHOLD? — 74
  - Y → MIN ← n — 75
    - Re(n) = Re{(n+MAX)/2} — 76
    - MAX − n < 1 — 77
  - N → MAX ← n — 78
    - Re(n) = Re{(n+MIN)/2} — 79
    - n − MIN < 1 — 80
- Re(E) = Re(n) — 83
- Re(B) = f{Re(N), Re(E)} — 84
- FINISH

25

FIGURE 15

FIGURE 16

POWER SUPPLY CIRCUIT

6

2 OSCILLATOR CIRCUIT

3 DETECTOR CIRCUIT

4 SIGNAL PROCESSER CIRCUIT

5 OUTPUT CIRCUIT OUTPUT

+V

0 V

1 L C

Re

R e ----- RESISTANCE USED TO ADJUST SENSITIVITY

FIGURE 17

2 OSCILLATOR CIRCUIT

FIG. 18 (a)

FIG. 18 (b)

FIGURE 19

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | DE-C-41 23 828 (GEBHARD BALLUFF FABRIK FEINMECHANISCHER ERZEUGNISSE GMBH & CO.) * column 4, line 18 - column 6, line 21; figures 3-6 * | 1-4 | H03K17/95 |
| A | US-A-3 833 850 (GÜNTHER WEBER) * column 2, line 13 - line 49 * * column 3, line 23 - line 34 * | 1-4 | |
| A | EP-A-0 171 013 (OMRON TATEISI ELECTRONICS CO.) * page 5, line 7 - line 13; figure 1 * | 1-4 | |
| A | US-A-4 068 189 (MICHAEL A. WILSON) * column 3, line 63 - column 4, line 4 * * column 9, line 61 - column 10, line 8 * * figures 7-9 * | 1-4 | |
| | | | TECHNICAL FIELDS SEARCHED (Int.Cl.6) |
| | | | H03K |

The present search report has been drawn up for all claims

| Place of search | Date of completion of the search | Examiner |
|---|---|---|
| THE HAGUE | 13 February 1995 | D/L PINTA BALLE.., L |